# EUROPEAN PATENT APPLICATION

(11) **EP 2 439 785 A2**
(43) Date of publication of application: **11.04.2012**
(21) Application number: 10822254.8
(22) Date of filing: 07.10.2010
(51) Int. Cl.: H01L 31/042

(54) **PHOTOVOLTAIC POWER-GENERATING APPARATUS AND METHOD FOR MANUFACTURING SAME**

(30) Priority: 07.10.2009 KR 20090095164
(71) Applicant: LG Innotek Co., Ltd., Seoul 100-714 (KR)
(72) Inventor: BAIK, Jung Shik, Seoul 100-714 (KR)
(74) Representative: Novagraaf Technologies
(86) International application number: PCT/KR2010/006869
(87) International publication number: WO 2011/043609

(57) **Abstract**

Disclosed are a solar cell apparatus and a method of fabricating the same. The solar cell apparatus includes a support substrate, a back electrode layer on the support substrate, a light absorbing layer covering the back electrode layer while exposing a first expose region of the back electrode layer, and a window layer covering the light absorbing layer while exposing a second expose region of the light absorbing layer. The above layers are formed by moving one mask at a predetermined pitch. The layers have step difference from each other, and are stacked on each other so that the layers are offset from each other by the predetermined pitch. The solar cell apparatus is fabricated by using one mask, so that the solar cell apparatus is very easily formed.

## Description

### [Technical Field]

The embodiment relates to a solar cell apparatus and a method of fabricating the same.

### [Background Art]

A solar cell module for converting photo energy into electric energy through the photoelectric transformation has been extensively used to obtain clean energy contributing to environmental conservation of the earth.

As the photoelectric transformation efficiency of a solar cell has been improved, a solar cell system including the solar cell module is used not only for the residential purpose, but for the building exterior materials.

### [Disclosure]

### [Technical Problem]

The embodiment provides a solar cell apparatus and a method of fabricating the same in which a number of solar cell apparatuses are simultaneously fabricated.

### [Technical Solution]

According to the embodiment, a solar cell apparatus includes a support substrate, a back electrode layer on the support substrate, a light absorbing layer covering the back electrode layer while exposing a first expose region of the back electrode layer, and a window layer covering the light absorbing layer while exposing a second expose region of the light absorbing layer.

According to the embodiment, a method of fabricating a solar cell apparatus includes forming a back electrode layer on a support substrate by using a mask, primarily moving the mask relative to the support substrate and forming a light absorbing layer on the back electrode layer by using the mask, and secondarily moving the mask relative to the support substrate and forming a window layer on the light absorbing layer.

According to the embodiment, a solar cell apparatus includes a support substrate, a back electrode layer having a first through hole on the support substrate, a light absorbing layer provided on the back electrode layer and having a second through hole beside the first through hole, and a window layer provided on the light absorbing layer and having a third through hole overlapping with the second through hole. Widths of the first, second, and third through holes correspond to each other.

### [Advantageous Effects]

As described above, according to the method of fabricating the solar cell apparatus of the embodiment, the back electrode layer, the light absorbing layer, and the window layer can be formed by using one mask. Accordingly, according to the solar cell apparatus of the embodiment, the replacement of the mask is not required to form the above layers.

In particular, according to the method of fabricating the solar cell apparatus of the embodiment, the back electrode layer, the light absorbing layer, and the window layer are continuously deposited through one vacuum process by controlling a mask in wireless.

In other words, according to the method of fabricating the solar cell apparatus of the embodiment, the solar cell apparatus divided into a plurality of cells can be easily fabricated by using one mask in one vacuum state.

Therefore, according to the method of fabricating the solar cell apparatus of the embodiment, an automation process can be easily employed solar cell apparatuses such as solar cell panels can be fabricated in bulk.

### [Description of Drawings]

FIG.1 is a plan view showing a mask used to fabricate a solar cell apparatus according to the embodiment; and

FIGS. 2 to 5 are sectional views showing the solar cell apparatus according to the embodiment.

### [Best Mode]

### [Mode for Invention]

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

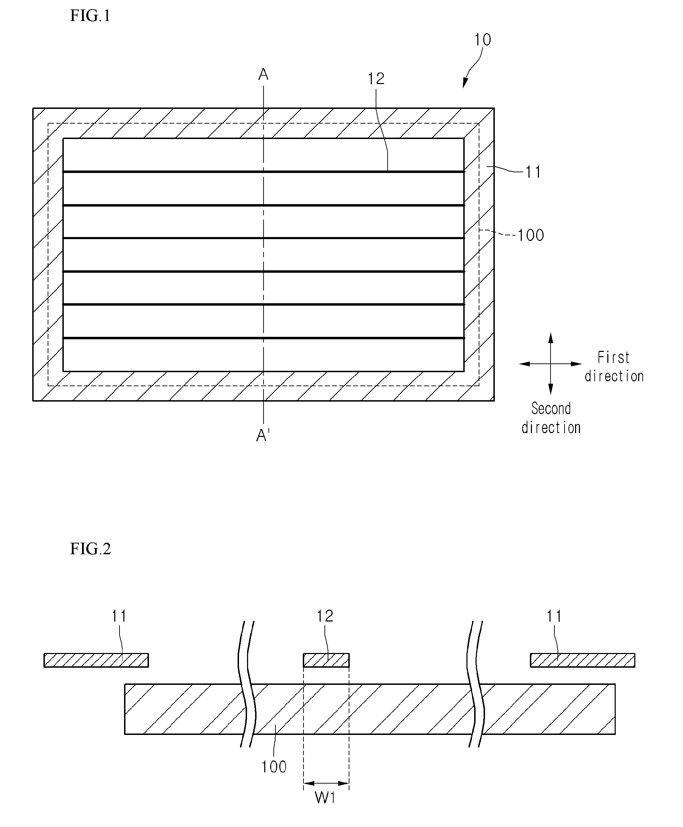

FIG.1 is a plan view showing a mask used to fabricate a solar cell apparatus according to the embodiment, and FIGS. 2 to 5 are sectional views showing the solar cell apparatus according to the embodiment.

Referring to FIGS. 1 and 2, a mask 10 is provided on a support substrate 100.

The support substrate 10 has a plate shape. The support substrate 10 includes an insulator. The support substrate 10 may include a glass substrate, a plastic substrate, or a metallic substrate.

In more detail, the support substrate 100 may include a soda lime glass substrate. The support substrate 100 may be transparent. The support substrate 100 may be rigid or flexible.

As shown in FIG. 1, the mask 10 includes a mask frame 11 and a plurality of mask patterns 12.

The mask frame 11 has a rectangular frame. When viewed in a plan view, the mask frame 11 may have a closed loop shape. In addition, when viewed in a plan view, the mask frame 11 is greater than the support substrate 100.

The mask frame 11 may include metal representing high heat resistance.

The mask patterns 12 are provided inside the mask frame 11. In addition, the mask patterns 12 are connected to the mask frame 11. The mask patterns 12 are provided in parallel while being spaced apart from each other by a predetermined distance.

The mask patterns 12 extend in a first direction. For example, a width W1 of each mask pattern 12 may be in the range of about 10µm to about 200µm. The mask patterns 12 may be spaced apart from each other by a predetermined interval. In addition, the mask patterns 12 may be provided in parallel to each other.

As shown in FIGS. 1 and 2, the mask frame 11 covers an outer portion of the support substrate 100. In other words, the mask frame 11 is provided corresponding to a region for the lateral surface of the support substrate 100.

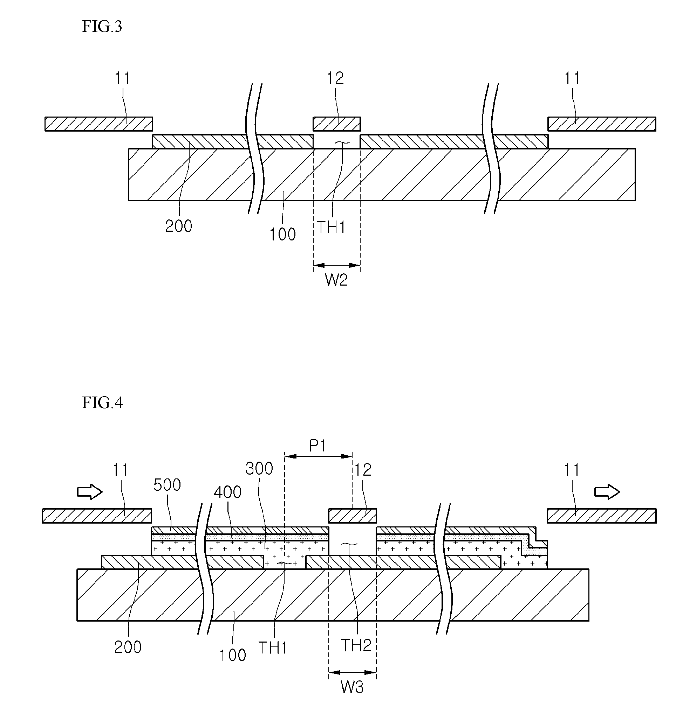

Referring to FIG. 3, a back electrode layer 200 is formed on the support substrate 100 by using the mask 10. In other words, after metal such as molybdenum (Mo) is deposited on the support substrate 100 through the mask 10, the back electrode layer 200 is formed.

The back electrode layer 200 may be formed through various schemes such as an evaporation scheme, a sputtering scheme, or a chemical vapor deposition scheme. In this case, the metal such as Mo is deposited at a region without the mask frame 11 and the mask pattern 12.

Therefore, the back electrode layer 200 is provided therein with first through holes TH1. The first through holes TH1 are defined at positions corresponding to the mask patterns 12.

A width W2 of each through hole TH1 may correspond to the width W1 of each mask pattern 12. In other words, the width W2 of the through hole TH1 may be substantially equal to the width of the mask pattern 12.

For example, the first through hole TH1 exposes the top surface of the support substrate 100, and may have a width in the range of about 10µm to about 100µm.

Referring to FIG. 4, the mask 10 relatively moves with respect to the support substrate 100 in a second direction. In other words, the mask 10 may move in the second direction, or the support substrate 100 may move in the second direction.

In this case, the mask 10 moves at a pitch P1 greater than the width W2 of the first through hole TH1. In other words, after the mask 10 has been moved, the mask pattern 12 moves beside the first through hole TH1.

Thereafter, a light absorbing layer 300, a buffer layer 400, and a high-resistance buffer layer 500 are sequentially formed on the back electrode layer 200 by using the mask 10.

The light absorbing layer 300 may be formed through a sputtering process, or an evaporation scheme.

For example, the light absorbing layer 300 may be formed through various schemes such as a scheme of forming a Cu(In, Ga)Se₂(CIGS) based-light absorbing layer 300 by simultaneously or separately evaporating Cu, In, Ga, and Se and a scheme of performing a selenization process after a metallic precursor film has been formed.

Regarding the details of the selenization process after the formation of the metallic precursor layer, the metallic precursor layer is formed on the back contact electrode 200 through a sputtering process employing a Cu target, an In target, or a Ga target.

Thereafter, the metallic precursor layer is subject to the selenization process so that the Cu(In,Ga) Se₂(CIGS) based-light absorbing layer 300 is formed.

In addition, the sputtering process employing the Cu target, the In target, and the Ga target and the selenization process may be simultaneously performed.

In addition, a CIS or a CIG light absorbing layer 300 may be formed through a sputtering process employing only Cu and In targets or only Cu and Ga targets and the selenization process.

Thereafter, cadmium sulfide is deposited on the light absorbing layer 300 through a sputtering process, and the buffer layer 400 is formed.

Then, after zinc oxide is deposited on the buffer layer 400 through a sputtering process, the high-resistance buffer layer 500 is formed.

In this case, second through holes TH2 are formed in the light absorbing layer 300, the buffer layer 400, and the high-resistance buffer layer 500 by using the mask 10. In more detail, the second through holes TH2 are formed corresponding to the mask patterns 12.

A width W3 of each second through hole TH2 is substantially equal to the width W1 of the mask pattern 12. The second through hole TH2 is formed through the light absorbing layer 300, the buffer layer 400, and the high-resistance buffer layer 500. The top surface of the back electrode layer 200 is exposed through the second through hole TH2.

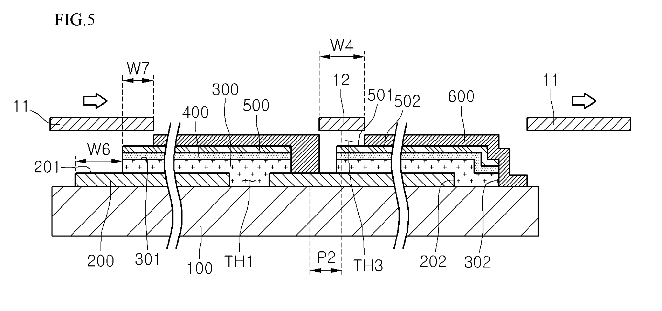

Referring to FIG. 5, the mask 10 relatively moves with respect to the support substrate 100 in the second direction. In other words, the mask 10 may relatively move in the second direction, or the support substrate 100 may move in a direction opposite to that of the mask 10.

In this case, the mask pattern 12 moves at a pitch P2 smaller than the width W3 of the second through hole TH2. In other words, the mask pattern 12 moves while overlapping with the second through hole TH2. For example, the mask pattern 12 moves at an half of the width W3 of the second through hole TH2.

Thereafter, a window layer 600 is formed on the high-resistance buffer layer 500 by using the mask 10. In order to form the window layer 600, transparent conductive material is stacked on the high-resistance buffer layer 500 through the mask 10. The transparent conductive material may include aluminum doped zinc oxide (AZO).

The mask pattern 12 partially overlaps with a part of the second through hole TH2. Therefore, the transparent conductive material is filled in the part of the second through hole TH2 due to the mask pattern 12.

In particular, the window layer 600 makes contact with the back electrode layer 200 by the transparent conductive material filled in the part of the second through hole TH2.

In addition, third through holes TH3 are formed through the window layer 600 by the mask 10. In other words, the third through holes TH3 are formed by the mask pattern 12.

A width W4 of each third through hole TH3 is substantially equal to the width W1 of the mask pattern 12. In addition, each third through hole TH3 partially makes contact with a part of each second through hole TH2.

In addition, the third through hole TH3 exposes a top surface 501 of the high-resistance buffer layer 500. In this case, the third through hole TH3 is not formed through a mechanical scribing process or a laser. Therefore, the top surface 501 of the high-resistance buffer layer 500 exposed through the third through hole TH3 and the top surface of the high-resistance buffer layer 500 covered by the window layer 600 are arranged on the same plane 502.

In addition, the back electrode layer 200, the light absorbing layer 300, the buffer layer 400, the high-resistance buffer layer 500, and the window layer 600 are divided by the first, second, and third through holes TH1, TH2, and TH3, thereby forming a plurality of solar cells.

As described above, since the first, second, and third through holes TH1, TH2, and TH3 are formed by the same mask pattern 12, the first, second, and third through holes TH1, TH2, and TH3 have widths corresponding thereto. In other words, the first, second, and third through holes TH1, TH2, and TH3 have a substantially identical width.

In addition, the back electrode layer 200, the light absorbing layer 300, and the window layer 600 are stacked on each other in the shape of a stair by the mask frame 11.

In other words, an outer portion of the back electrode layer 200 is not aligned in line with an outer portion of the light absorbing layer 300, but offset from each other by a predetermined distance. In other words, the back electrode layer 200 does not fully overlaps with the light absorbing layer 300, but the back electrode layer 200 partially overlaps with the light absorbing layer 300.

Therefore, the light absorbing layer 300 does not cover the whole top surface of the back electrode layer 200, but exposes a part (hereinafter, first expose region) of the top surface of the back electrode layer 200. In this case, a width W6 of the first expose region 201 corresponds to the pitch P1 between the first and second through holes TH1 and TH2.

The width W6 of the first expose region 201 corresponds to the misalignment degree between the back electrode layer 200 and the light absorbing layer 300. Therefore, the distance between one outer lateral surface of the back electrode layer 200 and one outer lateral surface of the light absorbing layer 300 corresponds to the width W6 of the first expose region 201.

Similarly, the outer region of the light absorbing layer 300 is not aligned in line with the outer region of the window layer 600, but offset from each other by a predetermined interval. In other words, the light absorbing layer 300 is not fully overlapped with the window layer 600, but partially overlaps with the window layer 600.

Therefore, the window layer 600 does not cover the whole top surface of the light absorbing layer 300, but exposes a part (hereinafter, second expose region 301) of the top surface of the light absorbing layer 300. In this case, a width W7 of the second expose region 301 corresponds to the pitch P2 between the second through hole TH2 and the third through hole TH3.

In other words, the width W7 of the second expose region 301 corresponds to the misalignment degree between the light absorbing layer 300 and the window layer 600. Therefore, the distance between one outer lateral surface of the light absorbing layer 300 and an outer lateral surface of the window layer 600 corresponds to the width W7 of the second expose region 301.

The first expose region 201 is defined in one outer portion of the back electrode layer 200. In addition, the second expose region 301 is defined in one outer portion of the light absorbing layer 300.

In detail, as a whole, the light absorbing layer 300 is provided on the back electrode layer 200 while forming the first step with respect to the back electrode layer 200. In addition, the window layer 600 is provided on the light absorbing layer 300 while forming the second step with respect to the light absorbing layer 300.

In this case, the back electrode layer 200, the light absorbing layer 300, and the window layer 600 are stacked on each other through the same mask 10. Therefore, the back electrode layer 200, the light absorbing layer 300, and the window layer 600 have surface areas corresponding to each other. In other words, the back electrode layer 200, the light absorbing layer 300, and the window layer 600 have a substantially identical surface area.

In addition, the light absorbing layer 300 covers one outer lateral surface 202 of the back electrode 200. In addition, the window layer 600 covers one lateral surface 302 of the light absorbing layer 600.

In the method of fabricating the solar cell apparatus according to the embodiment, the back electrode layer 200, the light absorbing layer 300, and the window layer 600 are formed by using one mask 10. Therefore, according to the solar cell apparatus of the embodiment, the replacement of the mask 10 is not required in order to form the layers 200, ..., and 600.

In particular, according to the method of fabricating the solar cell apparatus of the embodiment, the back electrode layer 200, the light absorbing layer 300, and the window layer 600 are continuously deposited through one vacuum process by controlling the mask 10 in wireless.

In other words, according to the method of fabricating the solar cell apparatus of the embodiment, the solar cell apparatus divided into a plurality of cells can be easily fabricated by using one mask 10 in one vacuum state.

Therefore, according to the method of fabricating the solar cell apparatus of the embodiment, an automation process can be easily employed solar cell apparatuses such as solar cell panels can be fabricated in bulk.

Although the accompanying drawings of the present embodiment show that the lateral surface of each layer and the internal lateral surface of each through hole are perpendicular to the support substrate 100, the perpendicular structure may not be exactly formed in a real process. For example, the lateral surface of each layer and the internal lateral surface of each through hole may be inclined with respect to the support substrate 100 or may form a curved surface with respect to the support substrate 100.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

The solar cell apparatus according to the embodiment is applicable to the field of solar power generation

## Claims

1. A solar cell apparatus comprising:
a support substrate;
a back electrode layer on the support substrate;
a light absorbing layer covering the back electrode layer while exposing a first expose region of the back electrode layer; and
a window layer covering the light absorbing layer while exposing a second expose region of the light absorbing layer.

2. The solar cell apparatus of claim 1, wherein the back electrode layer, the light absorbing layer, and the window layer have surface areas corresponding to each other.

3. The solar cell apparatus of claim 1, wherein the light absorbing layer covers an outer lateral surface of the back electrode layer, and the window layer covers an outer lateral surface of the light absorbing layer.

4. The solar cell apparatus of claim 1, wherein the back electrode layer is formed therein with a plurality of first through holes extending in a first direction,
the light absorbing layer is formed therein with a plurality of second through holes extending in the first direction while being adjacent to the first through holes, and
the window layer is formed therein with a plurality of third through holes extending in the first direction while overlapping with the second through holes, respectively.

5. The solar cell apparatus of claim 4, wherein a pitch between each first through hole and each second through hole corresponds to a width of the first expose region.

6. The solar cell apparatus of claim 4, wherein a pitch between each second through hole and each third through hole corresponds to a width of the second expose region.

7. The solar cell apparatus of claim 1, wherein the first expose region is defined at an outer portion of the back electrode layer, and the second expose region is defined at an outer portion of the light absorbing layer.

8. The solar cell apparatus of claim 1, wherein the light absorbing layer has a plane shape corresponding to a shape of the back electrode layer,
the light absorbing layer is stacked on the back electrode layer in such a manner that the light absorbing layer is offset from the back electrode layer by a predetermined interval,
the window layer has a plane shape corresponding to a shape of the light absorbing layer, and
the window layer is stacked on the light absorbing layer in such a manner that the window layer is offset from the light absorbing layer by a predetermined interval.

9. The solar cell apparatus of claim 1, wherein a distance between an outer lateral surface of the back electrode layer and an outer lateral surface of the light absorbing layer corresponds to a width of the first expose region, and a distance between an outer lateral surface of the light absorbing layer and an outer lateral surface of the window layer corresponds to a width of the second expose region.

10. The solar cell apparatus of claim 1, further comprising a buffer layer interposed between the light absorbing layer and the window layer, wherein the buffer layer has a plane shape corresponding to a shape of the light absorbing layer.

11. A method of fabricating a solar cell apparatus, the method comprising:
forming a back electrode layer on a support substrate by using a mask;
primarily moving the mask relative to the support substrate and forming a light absorbing layer on the back electrode layer by using the mask; and
secondarily moving the mask relative to the support substrate and forming a window layer on the light absorbing layer.

12. The method of claim 11, wherein the mask includes a plurality of mask patterns extending in a first direction and primarily and secondarily moves relative to the support substrate in a second direction crossing the first direction.

13. The method of claim 11, wherein a first through hole is formed in the back electrode layer by the mask in the forming the back electrode layer, a second through hole is formed in the light absorbing layer by the mask in the forming the light absorbing layer, and a third through hole is formed in the window layer by the mask in the forming the window layer.

14. The method of claim 13, wherein the second through hole is formed beside the first through hole, and the third through hole overlaps with the second through hole.

15. The method of claim 13, wherein the first through hole, the second through hole, and the third through hole are aligned in parallel to each other.

16. The method of claim 13, wherein the first through hole, the second through hole, and the third through hole are formed by a same mask pattern.

17. A solar cell apparatus comprising:
a support substrate;
a back electrode layer having a first through hole on the support substrate;
a light absorbing layer provided on the back electrode layer and having a second through hole beside the first through hole; and
a window layer provided on the light absorbing layer and having a third through hole overlapping with the second through hole,
wherein widths of the first, second, and third through holes correspond to each other.

18. The solar cell apparatus of claim 17, further comprising:
a buffer layer interposed between the light absorbing layer and the window layer; and
a high-resistance buffer layer interposed between the buffer layer and the window layer,
wherein a portion of a top surface of the high-resistance buffer layer is exposed by the third through hole.

19. The solar cell apparatus of claim 17, wherein the light absorbing layer is stacked on the back electrode layer in a stair shape, and a width of a top surface of the exposed back electrode layer corresponds to a pitch between the first through hole and the second through hole.

20. The solar cell apparatus of claim 17, wherein the window layer is stacked on a top surface of the light absorbing layer in a stair shape, and a width of a top surface of the exposed light absorbing layer corresponds to a pitch between the second through hole and the third through hole.
